# EUROPEAN PATENT APPLICATION

(11) **EP 4 788 071 A1**
(43) Date of publication of application: **05.08.2026**
(21) Application number: 25227313.1
(22) Date of filing: 27.12.2025
(51) Int. Cl.: H05K 5/06

(54) **INSULATING CASING FOR AN ELECTRONIC DEVICE PARTICULARLY A MAGNETIC THERAPY DEVICE**

(30) Priority: 04.02.2025 IT 202500001992
(71) Applicant: I.A.C.E.R. S.R.L., 30037 Scorze' (VE) (IT)
(72) Inventor: Zampolli, Giancarlo, 30037 Scorzè (IT); Zennaro, Matteo, 30037 Scorzè (IT); Marcon, Massimo, 30037 Scorzè (IT)
(74) Representative: Leganza, Alessandro

(57) **Abstract**

The invention concerns an insulating casing for an electronic device consisting of a body and one or more devices connected thereto. The casing is particularly suitable for use on medical devices, preferably magnetic therapy devices.

The casing consists of two parts: a "body casing", protecting the electronics and the sockets where peripherals are connected; a "peripheral casing", protecting the components in each peripheral and the housing where the cable end is inserted into the peripheral.

In both parts, the casing includes a one-piece resilient component made of silicone or rubber, which is sandwiched between two half-shells made of ABS or other rigid material.

Advantageously, the novel technical features of the casing make the device to which it is applied particularly robust, reliable, easy to use, and easy to sanitize. Thus, the device is suitable for use in critical environments and on patients or in harsh conditions, enabling the rental of the device in complete safety for the user, the rental company, and the manufacturer.

## Description

### TECHNICAL FIELD

The invention concerns technologies for protecting electronic devices from liquids, humidity, vapors and dust that can damage their internal components.

### BACKGROUND ART

A number of electronic devices requires technical solutions capable of ensuring a high degree of insulation for their internal components due to the fact that, during use, they may come into contact with fluids naturally present in the environment (e.g., water steam in a spa, rain), or produced by the users themselves (e.g., sweat or urine).

Relevant technical solutions for this invention include insulating casings for the device body or for the sockets of peripheral devices which are connected to the body itself.

Typical examples of devices that require a high degree of insulation for the user and the electronics during operation include: electrostimulators, magnetic therapy devices, heart rate monitors, Holter monitors, and other devices for measuring vital or functional parameters of patients or athletes.

These devices are admitted in the market subject to compliance with certain mandatory requirements to ensure user safety under all conditions of use envisaged by the regulations.

To comply with these standards, manufacturers are obviously required to develop solutions to isolate the device, which often conflict with the increasing complexity of its construction, particularly related to the need for multifunctionality and connectivity. These requirements must be implemented in a wearable product, or at least easily portable and usable by the user. Among the characteristics of the devices relevant to this invention is the resistance and protection of the casings for electrical equipment against the risk of intrusion of solids or liquids. This feature is regulated by a standard (CEI EN 60529/1997), and the degree of protection is expressed through the IP ("Ingress Protection") index, consisting of two numbers. The first expresses the degree of resistance to dust (it varies between 1 for protection against solid objects greater than 50 mm, to 6 for complete protection from dust) and the second to humidity and water (it varies between 1 for protection against dripping water, to 8 for protection against permanent immersion in water). For example, an IP61 enclosure ensures complete protection from dust and dripping water, while an IP65 enclosure ensures complete protection from dust and direct jets of water (but not from immersion, even temporary). Medical devices often have a degree of protection from IP61 to IP65.

Solutions for isolating electronic devices used in other industries such as the automotive sector, are not easily transferable to medical devices because they are too structurally complex, difficult to miniaturize, and often excessively expensive.

The scenario is even more complicated by a business trend that has become increasingly popular in recent years: the use of devices through rental.

This business model is related to the significant cost of professional medical devices, which is often not amortizable by the user due to sporadic or time-limited use, e.g., due to an occasional injury or a medical checkup.

Rental requires special construction features for the device, as it must withstand use (and sometimes misuse) by multiple users, continuous sanitization cycles with chemically aggressive liquids, and countless insertion/ removal cycles of peripherals (such as a magnetic therapy probe/applicator) in/from the device body. Over time, these factors can severely stress the device's insulation systems or connection systems and therefore the device itself. Furthermore, while users are required to read the device's user manual, improper or dangerous use (statistically more common in rentals) cannot be prevented, such as using a medical device that does not meet the IP65 rating (full protection against dust and jets of water) while showering or using an unsuitable device by a critically ill patient, such as a bedridden elderly patient at risk of urinary incontinence.

If misuse of the device causes a malfunction, or worse, a patient injury, such incidents might generate bad publicity for the device and potentially harm the manufacturer's reputation (certainly facilitated by the use of social media) although the manufacturer is not legally liable. Therefore, starting from the scenario explained hereinabove, the inventors intended to develop novel insulating solutions for electronic devices, particularly medical devices, that can be defined as "intrinsically safe", i.e. to be capable of meeting construction standards far exceeding those required by the reference standard, even under improper conditions of use. However, the problem of how to insulate electronic devices, especially electrostimulators and magnetic therapy devices, has not fully addressed as a careful state-of-the-art search showed. Therefore, there is an urgent need to improve the currently available solutions for insulating electronic devices, and particularly to provide novel insulating casing for electronic devices of the type consisting of a body connected to a peripheral device, such as a magnetic therapy applicator probe.

### DISCLOSURE OF INVENTION

### Object of the invention

The present invention intends to overcome the limitations and drawbacks of the solutions known in the art, by providing a novel insulating casing suitable for electronic devices, in particular medical devices, preferably devices for magnetotherapy.

Particularly, the main purpose of the invention is to provide an insulating casing for an electronic device consisting of a body which is connected through plugs/sockets to one or more peripherals e.g. magnetic therapy probes. This task includes providing an insulating casing capable of ensuring adequate protection against dust, liquids, vapor, steam, and other agents, to the electronics contained within the body, to the peripheral's internal components, as well as to the connection means of the peripheral to the body.

A second purpose of the present invention is to provide an insulating casing that is "intrinsically safe", i.e. to be capable of meeting construction standards far exceeding those required by the reference standard, to ensure protection even under improper or harsh conditions of use (sweating, incontinent patients). For example, this purpose includes creating a casing that meets a IP65 protection rating even if the reference standard for the sector requires a lower protection rating such as IP22.

A third purpose of the present invention is to provide a casing that ensures adequate protection without impairing the usability of the device, particularly the ease of inserting/removing peripherals in/from the device body or of setting operating modes by pressing suitable buttons. Last but not least, a purpose of the present invention is to provide a robust and easy to sanitize casing for a device, preferably a medical device, that can be used by a user through rental. Finally, a final purpose of the present invention is to provide an insulating casing for electronic devices that can be manufactured at a cost compatible with market needs, thus facilitating its widespread use.

### Technical solution

These and still other purposes, which shall appear more clearly hereinafter, are achieved by a novel insulating casing for an electronic device. The general features of said casing are defined by the enclosed claim 1, while the features of advantageous embodiments are set forth in the corresponding dependent claims.

The purpose of the invention is also achieved by a magnetotherapy device, protected by said insulating casing, as defined in the enclosed claim 22. The aforementioned claims, to which reference is made for the sake of brevity of exposition, are specifically and concretely defined below and are intended to be an integral part of this description.

In summary, the inventive concept underlying this invention involves a resilient component made of flexible material that insulates both the internal components and the peripheral connection sockets.

The resilient component can be divided into two distinct parts: the first part, named "body casing", to protect the electronics (including the circuit board and battery) and the sockets allowing connection of the peripherals to the device body; the second part, or "peripheral casing", to protect the components inside the peripherals and the peripheral cable insertion point.

Furthermore, the body casing incorporates significant technical solutions not found in prior art casings. These improve the usability of the buttons and their resistance to repeated on/off cycles, and ensure insulation even after repeated connection/disconnection cycles of the peripherals to the device body.

The present inventors have succeeded in integrating all these functional characteristics in a new single body resilient component, i.e. a single piece of silicone or rubber.

In both parts of the casing, the resilient component is sandwiched between two half-shells made of rigid material, which are shaped to cooperate with the distinguish features of the resilient component in order to achieve the purposes of the present invention.

The casing according to the present invention is particularly suitable for use on medical devices, preferably on magnetic therapy devices.

Advantageously, the technical features of the insulating casing make the device enclosed therein particularly robust, reliable, and easy to sanitize. This makes the device suitable for use in critical environments and on critical patients or in harsh conditions, enabling rental use under completely safe conditions for the user, the rental company, and the manufacturer.

### Brief description of drawings

The features and advantages of the present invention will be more fully understood by reference to the following drawings:
- Figure 1 shows a perspective view of the insulating casing according to the invention for the protection of an electronic device (B,P) consisting of a body (B) to which one or more peripherals (P) are connected. Figure 1(a) refers to the body casing, protecting the body (B), while Figure (b) refers to a peripheral casing for the protection of a peripheral (P);
- Figure 2 is a cross-section of the body casing of Figure 1(a), highlighting the first resilient component sandwiched between the first upper half-shell and the first lower half-shell;
- Figure 3 shows some construction details of the first resilient component according to a preferred embodiment, highlighting the recess, the perimeter edge, the grooves and the projecting parts;
- Figure 4 illustrates some construction details of the first resilient component according to a preferred embodiment, highlighting the key areas obtained on said resilient component;
- Figure 5, with reference to a preferred embodiment, shows the first upper half-shell (letter a) and the first lower half-shell (letter b). The inset highlights the edge of the first resilient component enclosed between the two half-shells;
- Figure 6 shows a perspective view of the body casing frame, highlighting the button activation mechanism associated to the key area;
- Figure 7 is a cross-section of the peripheral casing of Figure 1(a), highlighting the second resilient component (letter a), the second upper half-shell (letter b) and the second lower half-shell (letter c).
- Figure 8 illustrates (letter a), some construction details of the second resilient component according to a preferred embodiment of the invention, (letters b and c) show details of the perimeter edges of the half-shells according to alternative embodiments;
- Figure 9 is a perspective view of the first and second connection means for mechanically and electrically connecting the peripherals to the body of the device. Figure (a) shows male connection means, while Figure (b) shows female connection means;
- Figure 10 shows a perspective view of two cross-sections of the male connection means inserted into the female connection means as well as during insertion.

These drawings illustrate and demonstrate various features and embodiments of the present invention but are not to be construed as limiting the invention.

### Detailed Description

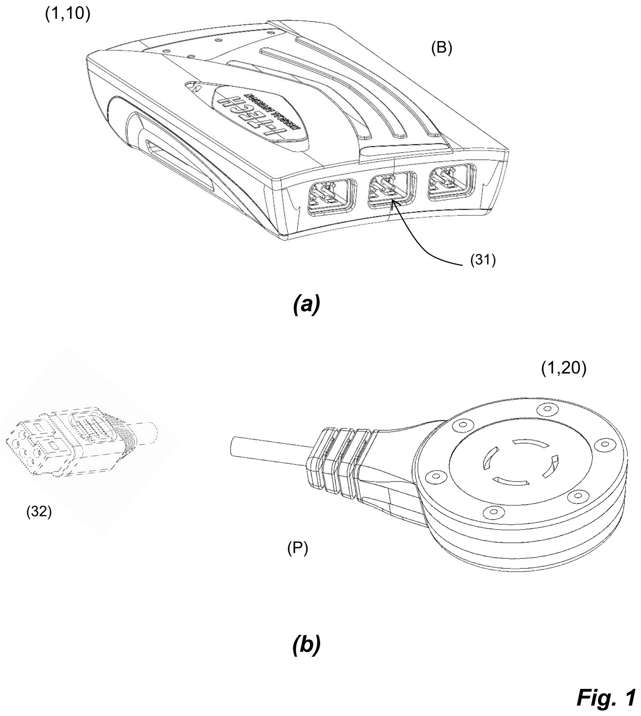

It is an object of this invention an insulating casing for an electronic device which is defined by the reference number (1) with reference to the enclosed Figure 1.

The insulating casing (1) according to the invention is intended for those electronic devices of the type consisting of a body (B), which includes an electronic board (PB) and first connection means (31), and one or more peripherals (P) each being provided with a connection cable whose free end has second connection means (32) electrically and mechanically connectable to said first connection means (31).

In the preferred embodiment, herein described by way of example and not limitation, the insulating casing (1) is intended for a magnetotherapy device.

As is known, this device is made up of a body (B), which manages the generation of variable voltage signals having an appropriate waveform, intensity and duration, and of one or more stimulating means (P), for the anatomical part to be treated, which receive such signals and emit electromagnetic waves via solenoids.

Therefore, It is also an object of the invention a magnetotherapy device equipped with said casing (1) and in particular comprising a body (B), protected by the body casing (10), and one or more peripherals (P), each being protected by the peripheral casing (20).

However, the insulating casing (1) according to the invention can also be advantageously applied to medical devices of other types or even to totally different non-medical devices provided they are made up of a body (B) to which it is possible to connect one or more peripherals (P) by means of appropriate connection means (31,32).

In any case, the electronic devices pertinent to this invention share the need to ensure a high degree of isolation for the user and the electronic board (PB) during operation, both in conditions characterized by high humidity, vapor or the presence of liquids, and when used by users with severe illness, such as bedridden or elderly patients.

For the sake of clarity, in this patent specification, the term "insulation" (or equivalently "insulating") shall mean blocking agents that could compromise the operation of the device (B,P), or cause injury to users even serious, in case they penetrate into the body (B) or peripherals (P) of the device. Such agents include the following: humidity, salt spray; liquids, such as water but also sanitizing or cleaning liquids; bodily fluids such as sweat and urine; vapor or steam; dust and dirt.

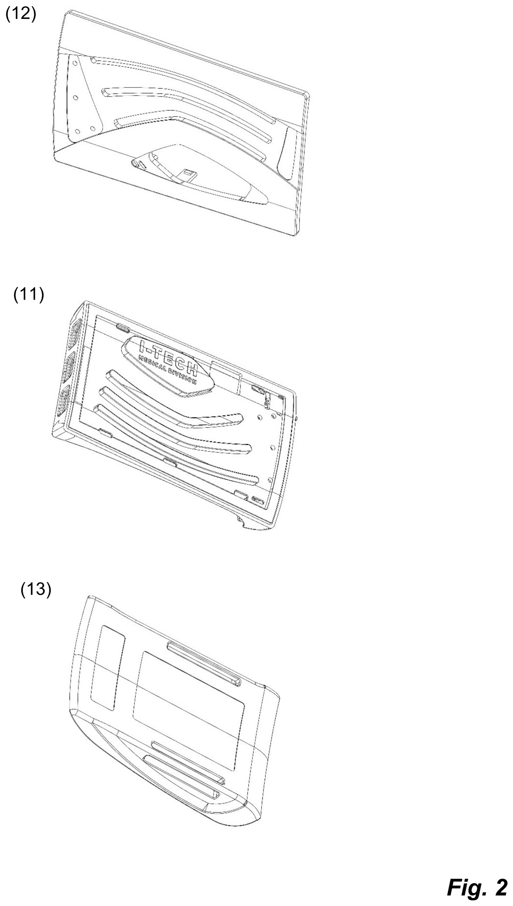

In the preferred embodiment, the first and second connection means (31,32) are plugs/sockets as those depicted in the enclosed Figure 2. They will be described in detail below.

The insulating casing (1) according to the invention is made up of a body casing (10), to protect the body (B) and one or more peripheral casings (20) to protect corresponding peripherals (P). For example, in the case of a magnetotherapy device equipped with three separate stimulating means (P), the insulating casing (1) is made up of a single body casing (10) and three peripheral casings (20).

### Description of the body casing (10)

With reference to the enclosed Figure 2, the body casing (10) comprises a first resilient component (11) made of flexible insulating material which is sandwiched between a first upper half-shell (12) and a first lower half-shell (13).

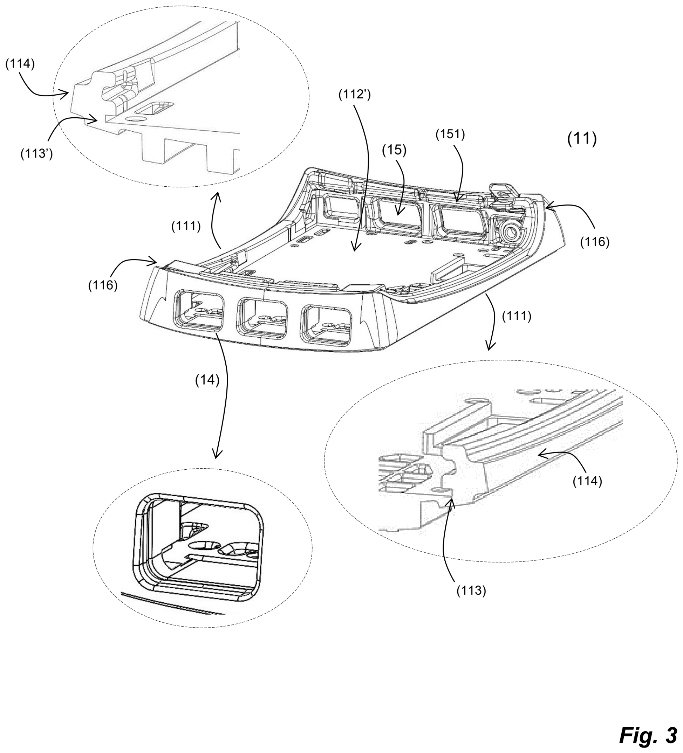

In particular, as highlighted by way of example and not limitation of the invention in the enclosed Figure 3, the first resilient component (11) is characterized by five features which are described below.

The first feature is the tray-like shape (111) which allows the electronic board (PB) to be housed and retained. For this purpose, on the inside edge of the frame (111) a recess (113) mating the profile (113') of the board (PB) is obtained. Preferably, the recess (113) extends along the entire perimeter edge of the frame (111) but could also be obtained only on some portions thereof, for example in correspondence with the edges of the board (PB).

In some preferred embodiments, the first resilient component (11) has a frame-like shape, characterized by a lower surface (112') surrounded along the perimeter by the frame (111).

The second characterizing feature of the first resilient component (11) is the presence of a first perimeter lip (114) formed externally along the frame (111). It is preferable that the perimeter lip (114) extends along the entire external edge of the first resilient component (11). However, the lip (114) can be obtained only on some portions of the frame (111). Furthermore, the perimeter lip (114) can have a constant or variable thickness. Preferably, said perimeter lip (114) has a "T-like" profile similar to the one shown in the insets of Figure 3.

In some preferred embodiments, the first resilient component (11) includes a third characterizing aspect consisting of one or more protruding elements (115) obtained on the lower surface (112') of the tray or along the frame in the upper/lower side, e.g. in correspondence with the edges (116). The protruding elements (115) can have various shapes: cylinders, prisms, or similar shapes, even in combination with each other as to form 3d broken lines, i.e. sequences of prisms or cylinders which in cross-section appear as broken lines. In any case, the protruding elements (115) act as matching parts to ensure that the device is correctly assembled and therefore perfectly sealed as will be explained below. Preferably, the protruding elements (115) are 3d broken lines protruding from the lower surface (112') of the tray. Although the protruding elements (115) have a technical function, clearly they can be selected in such a way as to give a distinctive aesthetic feature to the electronic device having the insulating casing (1) applied thereto.

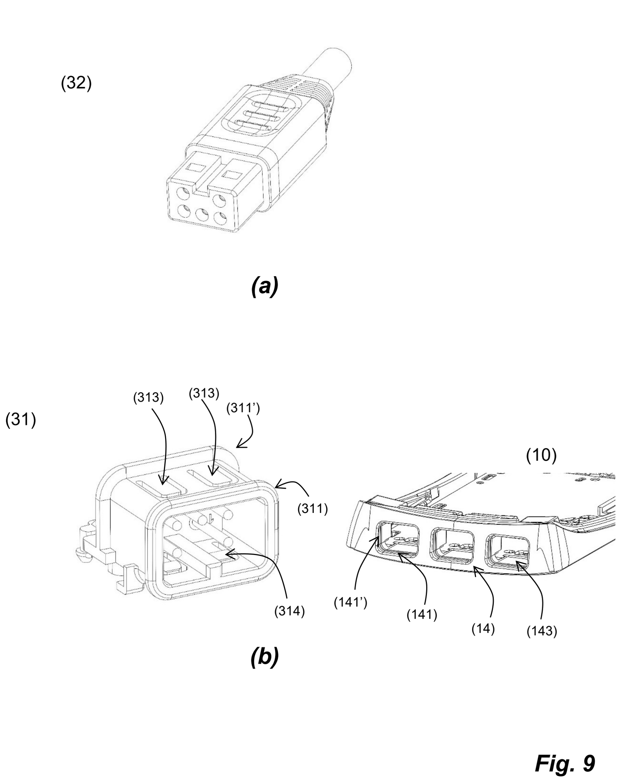

The fourth aspect characterizing the first resilient component (11) is the presence of one or more housings (14) configured to accommodate first or second connection means (31,32) such as those shown in Figure 9.

The fifth aspect of the first resilient component (11) concerns the internal surface of the housings (14) where retaining means (141) are obtained to block the first connection means (31) and prevent them from sinking into the housings (14), or being taken out of their seats, when the second connection means (32) are inserted or removed.

The retaining means take the form of grooves or projecting parts, preferably grooves.

Finally, the internal surface of the housings (14) includes a relief (142), which represents a final but fundamental measure adopted by the inventors to ensure high insulation of the electronic part enclosed in the body (B).

Since the retaining means (141) and the relief (142) cooperate closely with the connection means (31,32), further details will be provided later after their structure will be disclosed. Advantageously, the first resilient component (11) with the features described herein is characterized in that it is made as a single piece, preferably in rubber or silicone.

In the preferred embodiment, the housings (14) are placed along the frame (111) of the tray (Figure 1a) and are shaped to accommodate first female connection means (31).

However, for the purposes of implementing the present invention it is possible for the housings (14) to protrude from the lower surface (112') of the tray, based on requirements and features of the electronic device. It is also possible for the housings (14) to be shaped to accommodate male connection means (32).

Finally, in some preferred embodiments, the first resilient component (11) includes at least one key area (15) delimited by an engraved or debossed perimeter (151) obtained on the flexible material and characterized by a reduced-thickness part (152). Taking advantage that along such an engraved or debossed perimeter (151) the first resilient component (11) has a reduced thickness, the key area (15) has greater flexibility and can retract if the user exerts pressure on it. In this way, the user can activate a function, for example switching on the device, using an activation mechanism that makes the key area (15) mechanically integral with the button on the board (PB). The structure of this activation mechanism will be described later.

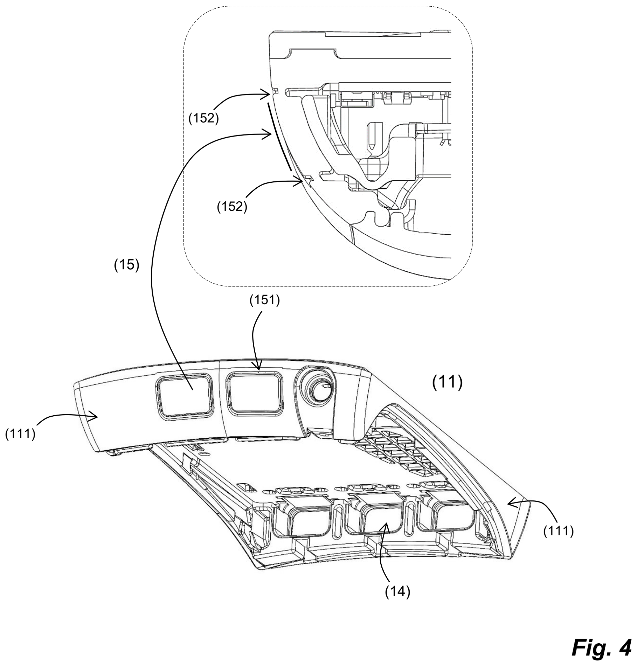

As illustrated by way of example in Figure 4, in the preferred embodiment, the first resilient component (11) includes two key areas (15) formed on the frame (111) of the tray, preferably on the opposite side with respect to the position of the housings (14).

In the preferred embodiment, the first resilient component (11) described above is made in a single piece.

As previously mentioned, the first resilient component (11) is placed between the first upper half-shell (12) and the first lower half-shell (13).

The two half-shells (12,13) have a substantially similar structure and are made as a single body with insulating material, preferably rigid, such as ABS or polycarbonate.

For the sake of clarity, it should be noted that the half-shells (12,13) do not necessarily have a concave or convex shape, as at least one of the two can have a different shape, such as flat or substantially flat, provided that the shape allows the half-shells (12,13) to be closed one against the other with the first resilient component (11) sandwiched therebetween.

For the sake of clarity, in the following the first reference in brackets refers to the upper half-shell while the second to the lower one. The upper and lower half-shells (12,13) include the following elements: a perimeter edge (121,131) where first upper and lower grooves (122,132) are obtained; first upper and lower closure means (123,133) attached to correspondent inner surfaces (124,134) so that the former (123) mates with the latter (133).

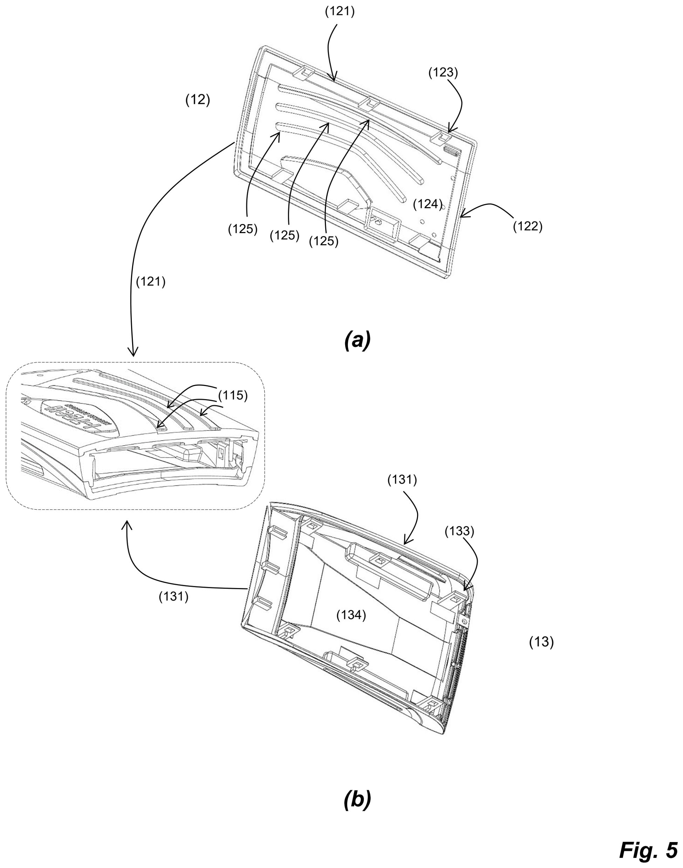

As illustrated in the enclosed Figure 5, the perimeter edge (121,131) of the half-shells is characterized by first upper and lower grooves (122,132) having a profile shaped so as to seat against the first perimeter lip (114) of the first resilient component (11) and to allow the perimeter lip (114) of the first resilient component (11) to protrude from the perimeter edge (121,131).

For example, if the first perimeter lip (114) has a T-shaped profile, the first upper and lower grooves (122,132) seat against the common segment of the profile on opposite sides so that the edge of the first perimeter lip (114) is in line with the perimeter edge (121,131). This configuration is illustrated by way of example and limitation of the invention in the inset of the enclosed Figure 5.

Preferably, the first perimeter lip (114) and the first upper and lower grooves (122,132) extend along the entire outer edge of the first resilient component (11) so that the body casing (10) has a perimeter sealing gasket (114) that is in line with the entire edge (121,131) of the two half-shells (12,13) when the insulating first resilient component (11) is sandwiched between the first upper half-shell (12) and the first lower half-shell (13).

It shall be evident to those skilled in the art that the first upper and lower grooves (122,132) can be obtained only on some portions of the perimeter edge (121,131) so that only some portions of the lip (114) protrude, preferably remaining in line with the edge (121,131) of the two half-shells (12,13).

Finally, as far as the first upper and lower closure means (123,133) are concerned, these could be of the type commonly used to close the half-shells of common electronic devices, for example: snap closures, screw closures, slide closures, teeth, slots, clips or similar.

In any case, the first closure means (123,133), by cooperating one with each other, close the first resilient component (11) between the two half-shells (12,13) ensuring the perfect seal of the body casing (10) from humidity, liquids or dust.

Continuing with the description of the two half-shells (12,13), in some preferred embodiments they further include insertion openings (125) for the protruding elements (115) of the first resilient component (11). The insertion openings (125) are characterized by a shape matching the protruding elements (115) of the first resilient component (11), so that, if the body casing (10) is closed correctly, the insertion openings (125) are perfectly sealed by the protruding elements (115) inserted therein.

In the preferred embodiment, only the first upper half-shell (12) is provided with insertion openings (125) and these take the form of a plurality of 3d broken lines.

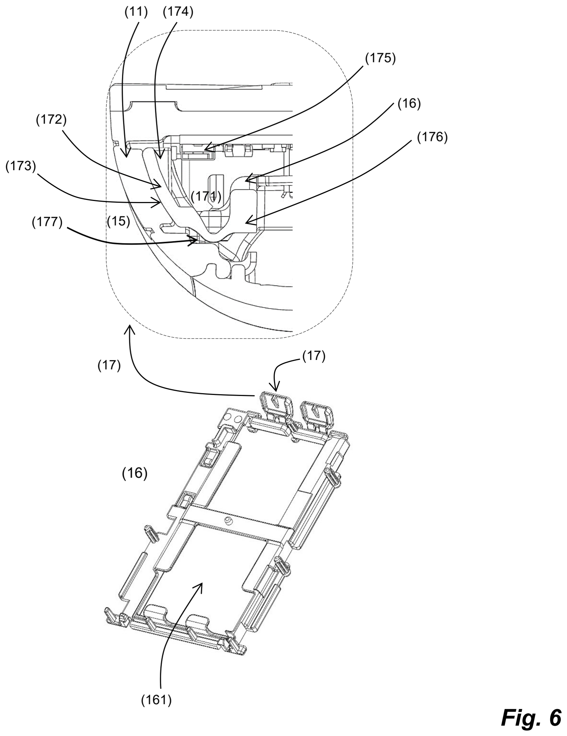

Finally, the body casing (10) according to the invention comprises a frame (16), shown in the enclosed Figure 6.

The frame (16) includes one or more housings (161) suitably conformed for housing auxiliary components of the electronic device (B,P), such as a memory unit, or the device's power battery. Furthermore, the frame (16) could include pins, spacers or feet to support the board (PB).

Finally, the frame (16) includes activation mechanisms (17) of the device's buttons (B,P). With reference to the inset of in Figure 6, each mechanism (17) includes a U-shaped body (171), having an external portion (172), an internal portion (176) and an intermediate portion (177). The external portion (172) is limited by: a first surface (173) in contact with the first resilient component (11) in correspondence with the key area (15) described previously; a second surface (174) in contact with the actuator (175) of the button on the board (PB).

The internal portion (176) is attached to the frame (16) and it is connected to the external portion (172) by means of the intermediate portion (177), which has a curved shape with a reduced thickness compared to the portions (172, 176).

Advantageously, the U-shaped body (171) shaped in this way behaves like an elastic element, even though it is made as a single body with a rigid plastic material, preferably the same material as the half-shells (12,13).

In this way, when the user applies pressure on the key area (15) of the device (B,P), this area retracts since it has a greater elasticity, which is due to the reduced-thickness perimeter part (152) of the first resilient component (11), and transmits the pressure to the external portion (172) of the body (171) and hence to the second surface (174). Finally, the pressure on the key area (15) makes possible the actuator (175) of the button on the board (PB) to be activated. Once the pressure is released, the key area (15) returns to its initial position thanks to the intermediate and internal portion (177,176).

From the description provided, it is evident that the elastic behavior of the body (171) thus configured and positioned is also determined by the flexible material of the first resilient component (11) which is in contact with the external portion (172).

Advantageously, this allows an activation mechanism (17) for the user keys to be provided which is integral with the frame (16) and is robust, precise as well as resistant to repeated on/off cycles. These characterizing features are not found in the state of the art. Furthermore, the activation mechanism (17) provides remarkable usability for the user. In fact, by appropriately sizing the key area (15) on the frame (111), and the corresponding external portion (172) of the body (171), it is possible to obtain a support surface for the user's finger having a reasonably large size for comfortable use. In this way, it is possible to overcome the usability problems of the device (B,P) related to the small size (typically 4x3 mm or 4x2 mm) of the keys present in the boards (PB) commonly on the market.

### Description of the peripheral casing (20)

As previously mentioned, along with the body casing (10) protecting the body (B) of the electronic device, in some preferred embodiments of the invention the insulating casing (1) includes one or more peripheral casings (20) protecting the peripherals (P) which can be connected to the body (B).

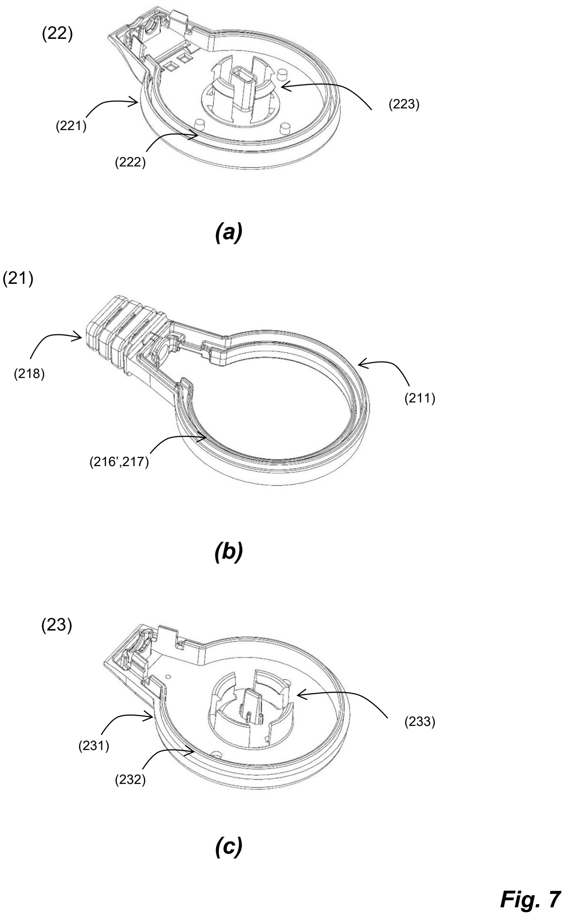

As illustrated in Figure 7, the peripheral casing (20) has a structure substantially similar to that of the body casing (10) and comprises: a second resilient component (21) which is made of a flexible insulating material as a single body; a second upper half-shell (22) and a second lower half-shell (23), configured so that the second resilient component (21) is sandwiched therebetween.

In particular, the second resilient component (21) comprises a ring part (211) shaped to accommodate a sensor or an emitter inside, and a terminal part (218) which protrudes from the ring part (211) and it is shaped to accommodate inside one end of the connection cable which, as mentioned, can be connected to the body (B) via the second connection means (32). Preferably, the ring part (211) has a circular cross-section, although it could have a different cross-section, such as a polygonal cross-section. Indeed, for the purposes of implementing the present invention, it is evident that the second resilient component (21) can have completely different shapes, such as a tray, provided that they are suitable to house a sensor, an emitter, or other device.

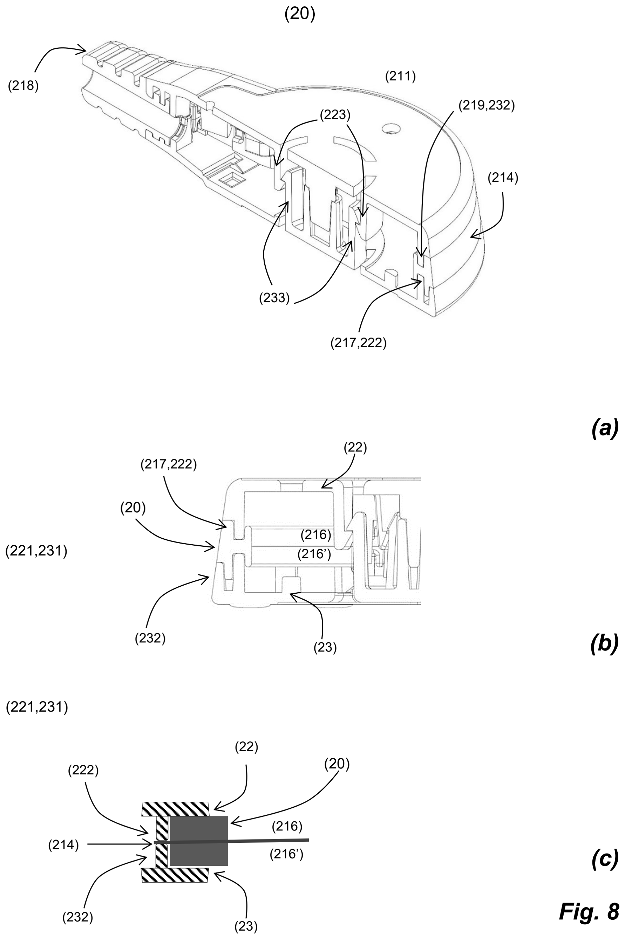

Starting from this general structure, the present inventors have identified various configurations of the second resilient component (21) to implement the present invention, which are illustrated by way of example and not limitation in the enclosed Figure 8.

In some preferred embodiments, the second resilient component (21) is characterized by a ring part (211) having a perimeter groove (217) obtained on the upper surface (216) of the second resilient component (21). Even more preferably, besides the perimeter groove (217), an additional perimeter groove (219) is made on the lower surface (216').

In both cases, the grooves (217,217') preferably extend along the entire perimeter of the second resilient component (21) and therefore along the perimeter of the ring part (211) and the terminal part (218). However, based on the structure of the peripherals (P), the grooves (217,217') could only obtained on some portions of the two parts (211,218).

In an alternative embodiment, the second resilient component (21) is free of grooves (217,217') and is characterized by the presence of a second perimeter lip (214) which extends externally along the entire perimeter edge of the ring (211) or only on some portions thereof.

Clearly, combinations of the embodiments described are possible if they are intended to guarantee the maximum degree of insulation based on the device (B,P) and its conditions of use.

In turn, the shape of the second resilient component (21) determines the shape of the two half-shells (22,23) which retain the second resilient component (21) sandwiched therebetween for the purpose of preventing contaminants to enter into the peripheral casing (20). Contaminants include humidity, liquids or dust, vapor or steam which could damage the sensor or the emitter. In the preferred embodiments that include perimeter grooves (217,217'), the half-shells (22,23) have second upper and lower grooves (222,232) obtained on the corresponding perimeter edges (221,231) of the half-shells (22,23). These grooves (222,232) are shaped so that they can be inserted into the respective perimeter grooves (217,217').

In a further preferred embodiment, illustrated in Figure 8(b), the second resilient component (21) does not include the additional groove (219) and consequently only the second upper groove (222) is shaped so that it can be inserted into the upper perimeter groove (217). In this case, the second lower groove (232) simply seats against the lower surface (216') of the second resilient component (21).

It shall be clear to those skilled in the art that the presence of at least one groove (217,217') is particularly advantageous, not only to ensure perfect insulation of the internal components but also to guide the correct assembly of the parts.

However, the presence of at least one of the grooves (217,217'), although desirable, is not necessary for the purposes of implementing the present invention.

Therefore, with reference to Figure 8(c), in an alternative embodiment, the half-shells (22,23) have second upper and lower grooves (222,232) shaped so as to seat, on opposite sides, against at least a part of the second perimeter lip (214) of the second resilient component (21) which in this case is without grooves (217,217').

In this embodiment, the perimeter lip (214) has the same function and shape as the perimeter lip (114) of the first resilient component (11), and is obtained along the external perimeter of the second resilient component (21) and preferably extends along its entire edge (21), even if it can only be obtained on some portions of the second resilient component (21).

In further embodiments, the second resilient component (21), similarly to the first (11), includes one or more protruding elements obtained on the upper or lower surface (216,216') along the ring (211). Further details on the protruding elements could be obtained by the skilled in the art from the description of the first resilient component (11).

In any case, as in the case of the body casing (10), the two upper and lower half-shells (22,23) according to the invention have a substantially similar structure and are made as a single body with insulating material, preferably rigid, for example ABS or polycarbonate.

In particular, they have second upper and lower closure means (223,233) fixed or obtained, respectively, on the internal surface of the second upper and lower half-shells (22,23).

As in the case of the first resilient component (11), second upper and lower closure means (223,233) of a known type can be used (e.g. snap-fit closures, snaps, screw closures, slide closures, clips, teeth or slots or similar closures) provided that they are suitable for retaining the resilient insulating component (21) when it is sandwiched between the second upper half-shell (22) and the second lower half-shell (23) with the second upper and lower grooves (222,232) inserted in the corresponding upper and lower perimeter grooves (217',217) or seating against the upper and lower surface (216,216') respectively.

### Description of the connection means

As mentioned at the beginning of the description, the insulating casing according to the invention is intended for those electronic devices of the type consisting of a body (B) that includes an electronic board (PB) and first connection means (31), and by one or more peripherals (P), each being provided with a connection cable whose free end has second connection means (32) electrically and mechanically connectable to said first connection means (31).

The connection means on the body (B) of the device, especially if of the female type, represents a critical element for the penetration of liquids, humidity and dust inside the device (B,P). However, a reliable known solution suitable for this invention was not found by the present inventors. Therefore, they had to develop a novel concept of connection means (31,32) whose features are disclosed in the following.

As will appear below, the technical expedient used for the connection means (31,32) are designed to cooperate with those present on the first resilient component (11) for the purposes of implementing this invention, in particular to insulate the electronic part from agents such as humidity, liquids, dust and dirt, vapor or steam even when used in harsh conditions or by critical users.

For the sake of clarity, in the present patent specification the terms "female sockets" and "male sockets" are intended to designate a connector such as that illustrated in Figure 9(b) and Figure 9(a) respectively.

In the preferred embodiment, the first connection means (31) are all female sockets, and correspondingly the second connection means (32) are all male sockets. In this case, each housing (14) obtained on the first resilient component (11) is shaped to accommodate a female connection means (31).

In this embodiment, the first connection means (31) are mid-mount female connectors, while the second connection means (32) are male connectors.

Furthermore, the connection means (31,32) are of the "side entry" type and the housings (14) are arranged on one side of the first resilient component (11) as shown in Figure 1. Advantageously, this solution allows the overall size of the body (B) of the magnetotherapy device to be reduced.

Different configurations are possible, for example the first connection means (31) can also be male plug, while the second connection means (32) can be female sockets.

Each insulating housing (14) includes retaining means to prevent the female connection means (31) to be pulled out of its housing (14) when the male connection means (32) is removed, or vice versa to prevent the female connection means (31) from sinking into the housing (14) during the insertion of the male connection means (32).

For this purpose, the housing (14) has inside retaining means (141) in the form of one or more grooves, shaped to mate with corresponding projecting part (311) obtained on the female connection means (31). The grooves (141) can extend along the entire internal surface of the housing (14) or only on some portions, for example the upper and lower walls of the housing (14). Similar considerations apply to the projecting part (311') present on the connection means (31).

With reference to the enclosed Figure 9, in the preferred embodiment each housing (14) has two grooves (141,141'). The grooves (141,141') extend around the entire internal surface of the housing (14), the first near the exit and the other on the opposite side, and are shaped to mate with corresponding perimeter projecting parts (311,311) obtained on the female connection means (31).

Even if this arrangement for the retaining means is preferable, it is clear that alternative embodiments are possible. For example, the projecting parts could be obtained on the internal walls of the housing (14) while the corresponding grooves on the external surface of the female connection means (31). Combinations of this solution with the preferred embodiment are also possible provided they are functional to improving the level of seal of the retaining means. The present inventors have experimentally found that the coupling based on grooves/projecting part herein described allow the female connection means (31) to be stably retained in its housing (14) despite the first resilient component (11) being made of flexible material. In fact, the present inventors have advantageously exploited the fact that, once the board (PB) is inserted inside the frame (111), the rigidity of the first resilient component (11) increases.

The body of the female connection means (31) includes fins (313) having teeth (314) protruding therefrom, to ensure that the male connection means (32), once inserted into the female connection means (31), is held stably in its seat during use and is prevented to accidentally come out of the housing (14). The fins (313) have teeth (314) protruding therefrom, which are shaped to mate with corresponding grooves (323) made on the body of the male connection means (32).

With reference to the enclosed Figure 9(b), in the preferred embodiment there are four fins (313) arranged two-by-two in the upper and lower part of the body of the female connection means (31). The four teeth (314) mate with the same number of grooves (323), which are obtained on the male connection means (32) and have shape and position corresponding to the teeth (314).

By advantageously tailoring the teeth (314) and corresponding grooves (323), e.g. by selecting profiles, dimensions, thickness and material to make the fins (313), it is possible to obtain a mechanical interference between parts that prevents an accidental decoupling of the connection means (31,32) and at the same time facilitate the male/female connection means (31,32) to be disconnected when desired.

In particular, teeth (314) and corresponding grooves (323) have profiles selected so that they are not too sharp. In addition, fins (313) are made of a material having suitable elasticity.

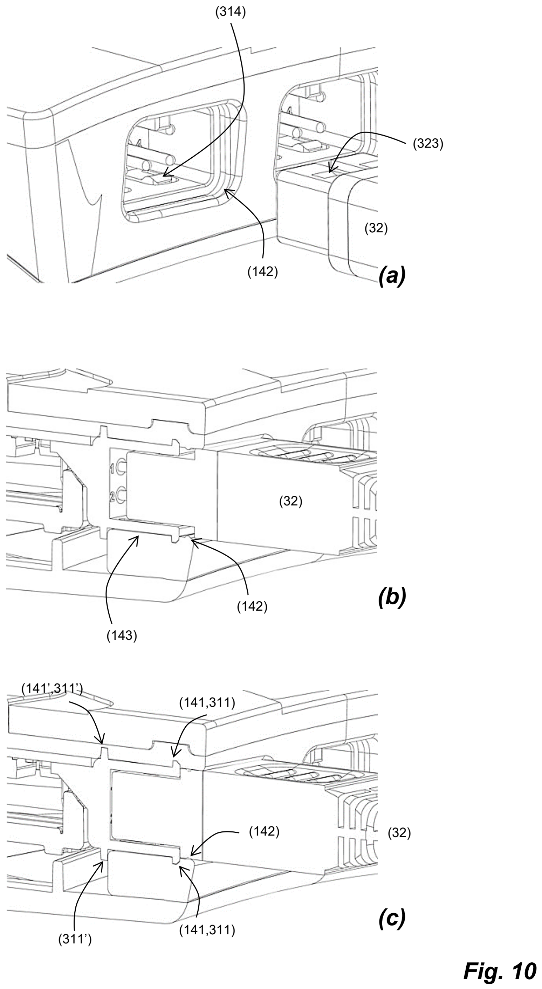

As shown in Figure 10, the first resilient component (11) is in contact with the external surface of the female connection means (31). This arrangement has two advantages: first, the openings around the fins (313) on the body are sealed, preventing liquids, vapors, and dust from infiltrating; second, it allows the mechanical interference between the teeth (314) and the grooves (323) to be tailored because the elastic behavior of the fins (313) is also determined by the flexible material of the first resilient component (11).

Finally, a last but fundamental solution adopted by the inventors to ensure high insulation when the male connection means (32) is inserted into the female connection means (31), is a relief (142) obtained on the external part of the housing (14).

As shown in the enclosed Figure 10(a) and Figure 10(b), the relief (142) develops around the entire surface of the housing (14) in proximity to the free entrance. Once the connection means (31,32) are coupled together the relief (142) seats against the external surface of the male connection means (32) making the coupling proof against the penetration of liquids, humidity, vapor and dust and also isolating the electrical signals through the conductors.

Thanks to the solution disclosed, the present inventors have developed a peripheral body connection means, which has proven to be mechanically-stable and capable to provide insulation from liquids, humidity and dust even under heavy-duty conditions of use.

In this way, one of the main purposes of the invention is achieved.

### CONCLUSIONS

To conclude, it has been shown that the invention described hereinabove fully achieves the intended aim and objects.

Furthermore, it shall be apparent to those skilled in the art that the insulating casing having the distinguishing features disclosed herein is novel, and its development required significant inventive effort. Furthermore, the insulating casing is particularly useful when applied to a medical device in particular a magnetic therapy device.

It is worth noting that although the description and examples provided contain many details, these should not be construed as limiting the scope of the invention but simply as illustrations of some embodiments of the present invention. Therefore, the present disclosure is not limited to the exemplary embodiments shown and described herein.

Hence, any modification of the present invention which falls within the scope of the following claims is considered to be part of the present invention.

Where the characteristics and techniques mentioned in any claim are followed by reference signs, these reference marks have been applied solely for the purpose of increasing the intelligibility of the claims and consequently these reference marks have no limiting effect on the interpretation of each element identified by way of example from these reference signs.

## Claims

1. Insulating casing (1) for an electronic device of the type consisting of a body (B), which includes an electronic board (PB) and first connection means (31), and by one or more peripherals (P) each being provided with a connection cable whose free end has second connection means (32) connectable to said first connection means (31), said casing (1) consisting of a body casing (10), for the protection of the body (B), and one or more peripheral casings (20) for the protection of corresponding peripherals (P), said casing (1) **characterized in that** the body casing (10) comprises:
- a first resilient component (11) made in a single piece with flexible insulating material, said component (11) comprising a frame (111) having one or more insulating housings (14) for said first or second connection means (31,32), said frame (111) having on the internal part a recess (113) obtained along the entire perimeter edge of the frame (111), or only on some portions thereof, said recess (113) configured to match the profile (113') of the board (PB) so as to accommodate and retain inside the frame (111) at least a part of the perimeter edge of the electronic board (PB), said frame (111) having on the external part a first perimeter lip (114), which develops along the entire perimeter edge of the frame (111) or only on some portions thereof;
- a first upper half-shell (12) made in a single piece with insulating material and having: a perimeter edge (121) with a first upper groove (122) obtained thereon, shaped so as to reach the closure position on at least a part of said first perimeter lip (114); first upper closure means (123) fixed to the internal surface (124) of the first upper half-shell (12);
- a first lower half-shell (13) made in a single part with insulating material and having:
a perimeter edge (131) including a first lower groove (132) obtained thereon,
shaped so as to reach the closure position with at least a part of said first perimeter lip (114); first lower closure means (133) fixed to the internal surface (134) of the
first lower half-shell (13) so as to match with said first upper closure means (123), wherein said body casing (10) has a perimeter sealing gasket (114) along the entire edge (121,131) of said half-shells (12,13), or only on some portions thereof, when the resilient insulating component (11) is placed between the first upper half-shell (12) and the first lower half-shell (13) and said half-shells (12,13) are joined together by means of closure means (123,133), said sealing gasket (114) having constant or variable thickness.

2. Insulating casing (1) according to claim 1 wherein the first resilient component (11) has a tray-shape formed by a lower surface (112') limited peripherally by the frame (111).

3. Insulating casing (1) according to claim 1 or 2 wherein:
- the first resilient component (11) further comprises one or more protruding elements (115) that protrude from the lower surface (112') of the tray or from the frame, for example at the edges (116); and
- the first upper half-shell (12) comprises insertion openings (125) for said protruding elements (115); and
- optionally, the first lower half-shell (13) comprises insertion openings for said protruding elements (115),
wherein said protruding elements (115) can be inserted into said correspondingly shaped abutment openings (125) so as to seal said openings (125).

4. Insulating casing (1) according to one or more of the preceding claims wherein the first resilient component (11) further comprises at least one key area (15) limited by a reduced-thickness perimeter part (152), which is configured to have a lower resilience if the user applies pressure on said key area (15), wherein the key area (15) is obtained on the frame (111) or on the lower surface (115') of the first resilient component (11).

5. Insulating casing (1) according to one or more of the preceding claims wherein the body casing (10) further comprises a frame (16) which includes one or more housings (161), one of which is intended to accommodate a battery for powering the device (B,P).

6. Insulating casing (1) according to claims 4 and 5 wherein the frame (16) includes at least one activation mechanism (172) for a button of the device (B,P), said mechanism including a shaped elastic body (171) having:
- an external portion (172), limited by a first surface (173) in contact with the first resilient component (11) at said key area (15), and by a second surface (174) in contact with the actuator (175) of the button on the board (PB), wherein the key area (15) has a much larger surface than that of the actuator (175);
- an internal portion (176) fixed to the frame (16) and mechanically connected to the external portion (172) by means of an intermediate portion (177), which has a curved shape, and optionally a reduced thickness compared to the portions (172,176),
wherein said activation mechanism (17) is able to assume:
- an "ON" state when a user applies pressure to the key area (15) which propagates through the elastic body (171) to the actuator (175) of the button on the board (PB) so that the actuator (175) switches from a non-activated state to an activated state;
- an "OFF" state when the user stops applying pressure to the key area (15) and the actuator (175) switches from the activated state to the non-activated state by releasing the activation pressure through the elastic body (171).

7. Insulating casing (1) according to claim 6 wherein the elastic body (171) is in contact with a portion of the first resilient component (11) so that the flexible material of said portion modulates the elastic behavior of said body (171).

8. Insulating casing (1) according to one or more of the preceding claims wherein:
- the first connection means (31) are female connectors of the *"mid-mount"* type or *"side entry*" type and the second connection means (32) are male connectors;
- the housing (14) includes retaining means to prevent the movement of the female connection means (31) during the removal or insertion operations of the male connection means (32).

9. Insulating casing (1) according to claim 8 wherein said retaining means are one or more grooves or projecting part (141) shaped so as to match with correspondingly shaped projecting part or grooves (311) which are on the external surface of the female connection means (31), wherein said grooves or projecting part (141,311) develop over the entire surface or only on some parts of the housing (14) or of the female connection means (31).

10. Insulating casing (1) according to one or more of the preceding claims wherein:
- the body of the female connection means (31) has elastic fins (313) limited by perimeter openings, said fins (313) having teeth (314) protruding therefrom;
- the body of the male connecting means (32) has grooves (323) matching the teeth (314), and shaped to cause mechanical interference between said grooves (323) and said teeth (314),
wherein the level of mechanical interference is selected to prevent accidental uncoupling of the connecting means (31,32) and at the same time to facilitate their separation when needed, wherein said level of mechanical interference is set by selecting: the profile of the teeth (314) and of the corresponding grooves (323), the dimensions and thickness of the teeth (314) and of the corresponding grooves (323), the material of the bodies of the connecting means (31,32).

11. Insulating casing (1) according to claim 10 wherein a portion (143) of the internal surface of the housing (14) is in contact with the openings of the corresponding body of the female connection means (31) so that said portion modulates the mechanical interference between the teeth (314) and the grooves (323) and at the same time seals said openings.

12. Insulating casing (1) according to claim 10 or 11 wherein the housings (14) have a relief (142) that extends along the entire internal surface of the housing (14), or only on some parts, said relief (142) which seats against the external surface of the male connection means (32) when the male connection means (32) is inserted into the female connection means (31), said relief (142) which in association with said portion (143) makes the connection (31,32) liquid-tight, humidity-tight, dust-tight and contaminant-tight, and also isolates electrical signals passing through the conductors of the connection (31,32).

13. Insulating casing (1) according to one or more of the preceding claims **characterized in that** the peripheral casing (20) comprises:
- a second resilient component (21) made in a single piece with flexible insulating material, said component (21) comprising a frame part (211), preferably in the shape of a ring or tray, shaped so as to accommodate inside a device, preferably a sensor or an emitter, said part (211) having on the upper surface (216) of the second resilient component (21) an upper perimeter groove (219) obtained thereon, said groove (219) which extends along the entire perimeter of the second resilient component (21), or only on some portions thereof, said second resilient component (21) also comprising a terminal part (218) which protrudes from said part (211) and accommodates the connection cable inside, said cable whose free end has second connection means (32);
- a second upper half-shell (22) made in a single piece with insulating material and having: a perimeter edge (221) with a second upper groove (222) obtained thereon, shaped so as to be insertable in said upper perimeter groove (219); second upper closure means (223) fixed to the internal surface of the second upper half-shell (22);
- a second lower half-shell (23) made in a single piece with insulating material and having: a perimeter edge (231) with a second lower groove (232) obtained thereon, shaped so as to reach the closure position on at least a part of the lower surface (216') of the second resilient component (21); second lower closure means (233) fixed to the internal surface so as to match with said first upper closure means (223),
wherein said peripheral casing (20) isolates the device from contaminants, such as humidity, liquids or dust, when the second resilient component (21) is interposed between the second upper half-shell (22) and the second lower half-shell (23) with the second upper groove (222) inserted into the upper perimeter groove (219), and said half-shells (22,23) are joined together by the closure means (223,233).

14. Insulating casing (1) according to claim 13 **characterized in that** the peripheral casing (20) further comprises:
- a lower perimeter groove (217) obtained on the lower surface (216') of the second resilient component (21), said groove (219) which extends along the entire perimeter of the second resilient component (21), or only on some portions thereof;
- a second lower groove (232) shaped so as to be insertable into said lower perimeter groove (217),
wherein said peripheral casing (20) isolates said device from contaminants, such as humidity, liquids or dust, when the second resilient component (21) is interposed between the second upper half-shell (22) and the second lower half-shell (23) with the second upper groove (222) inserted into the upper perimeter groove (219) and the second lower groove (232) inserted into the lower perimeter groove (217), and said half-shells (22,23) are joined together by means of the closure means (223,233).

15. Insulating casing (1) according to one or more of the preceding claims **characterized in that** the peripheral casing (20) comprises:
- a second resilient component (21) made in a single piece with flexible insulating material, said component (21) comprising a ring-shaped part (211) shaped so as to accommodate a device inside, preferably a sensor or an emitter, said ring-shaped part (211) having a second perimeter lip (214) obtained externally thereon, said ring-shaped part (211) which extends along the entire perimeter of the second resilient component (21), or only on some portions thereof, said second resilient component (21) also comprising a terminal part (218) which protrudes from said ring-shaped part (211) and accommodates the connection cable inside, said cable whose free end has second connection means (32);
- a second upper half-shell (22) made in a single piece with insulating material and having: a perimeter edge (221) with a second upper groove (222) obtained thereon, said groove (222) shaped so as to reach the closure position on at least a part of the upper surface (216) of the second resilient component (21); second upper closure means (223) fixed to the internal surface of the second upper half-shell (22);
- a second lower half-shell (23) made in a single piece with insulating material and having: a perimeter edge (231) with a second lower groove (232) obtained thereon, said groove (222) shaped so as to reach the closure position on at least a part of the lower surface (216') of the second resilient component (21); second lower closure means (233) fixed to the internal surface so as to correspond to the second upper closure means (223),
wherein said peripheral casing (20) isolates said device from contaminants, such as humidity, liquids or dust, when the resilient component (21) is interposed between the second upper half-shell (22) and the second lower half-shell (23) and said half-shells (22,23) are joined together by the closure means (223,233).

16. Insulating casing (1) according to one or more of the preceding claims wherein:
- the resilient components (11,21), are made of flexible material selected from the group consisting of: rubber, silicone, or materials having similar viscoelastic properties, a combination thereof.
- the upper half-shells (12,22) are made of a rigid or semi-rigid material, preferably ABS, or similar materials;
- the lower half-shells (13,23) are made of a rigid or semi-rigid material, preferably ABS, or similar materials.

17. Insulating casing (1) according to one or more of the preceding claims which has a resistance to the penetration of liquids, humidity, dust and contaminants capable of damaging electronic parts and devices contained in the body casing (10) or in one or more peripheral casings (20), wherein the resistance to the penetration of liquids is rated IP65 or alternatively at least IP22.

18. A magnetotherapy device (2) of the type formed by:
- a body (B) including an electronic board (PB) and first connection means (31); and
- one or more stimulation means (P) connected to said first connection means (31) by means of corresponding second connection means (32),
said magnetotherapy device (2) **characterized in that:**
- the body (B) is protected by a body casing (10) according to one or more of claims 1 to 12 and 16 to 17, and
- each of the stimulation means (P) is protected by a peripheral casing (20), according to one or more of claims 13 to 17.
